(19) Europäisches Patentamt
European Patent Office
Office européen des brevets

(11) **EP 1 387 409 B1**

(12) **FASCICULE DE BREVET EUROPEEN**

(45) Date de publication et mention
de la délivrance du brevet:
**20.04.2016   Bulletin 2016/16**

(51) Int Cl.:
***H01L 31/09*** *(2006.01)*   ***H01L 31/16*** *(2006.01)*

(21) Numéro de dépôt: **03101866.6**

(22) Date de dépôt: **25.06.2003**

(54) **Commutateur optoélectronique ultra rapide à grand pouvoir d'isolement et large bande passante**

Hochisolierter extrem schneller optoelektronischer Schalter mit grosser Bandbreite

Ultra-fast optoelectronic switch highly insulated and with wide bandwidth

(84) Etats contractants désignés:
**AT BE BG CH CY CZ DE DK EE ES FI FR GB GR HU IE IT LI LU MC NL PT RO SE SI SK TR**

(30) Priorité:   **28.06.2002   FR 0208129**

(43) Date de publication de la demande:
**04.02.2004   Bulletin 2004/06**

(73) Titulaire: **Thales**
**92400 Courbevoie (FR)**

(72) Inventeurs:
- **Formont, Stéphane**
  **Thales Intellectual Property**
  **94117 Cedex, Arcueil (FR)**
- **Chazelas, Jean**
  **Thales Intellectual Property**
  **94117 Cedex, Arcueil (FR)**
- **Algani, Catherine**
  **Thales Intellectual Property**
  **94117 Cedex, Arcueil (FR)**
- **Alquie, Georges**
  **Thales Intellectual Property**
  **94117 Cedex, Arcueil (FR)**
- **Canseliet, Charlotte**
  **Thales Intellectual Property**
  **94117 Cedex, Arcueil (FR)**
- **Deshours, Frédérique**
  **Thales Intellectuel Property**
  **94117 Cedex, Arcueil (FR)**

(74) Mandataire: **Lucas, Laurent Jacques et al**
**Marks & Clerk France**
**Conseils en Propriété Industrielle**
**Immeuble Visium**
**22, Avenue Aristide Briand**
**94117 Arcueil Cedex (FR)**

(56) Documents cités:
**US-A- 4 403 239     US-A- 4 843 446**
**US-A- 5 514 996**

- **PFEIFER T ET AL: "Picosecond Optoelectronic On-Wafer Characterization of Coplanar Waveguides on High-Resistivity Si and Si/SiO2 Substrates" MICROELECTRONIC ENGINEERING, ELSEVIER PUBLISHERS BV., AMSTERDAM, NL, vol. 31, no. 1, 1 février 1996 (1996-02-01), pages 385-395, XP004006650 ISSN: 0167-9317**
- **ITATANI T ET AL: "ULTRAFAST METAL-SEMICONDUCTOR-METAL PHOTOCONDUCTIVE SWITCHES FABRICATED USING AN ATOMIC FORCE MICROSCOPE" JAPANESE JOURNAL OF APPLIED PHYSICS, PUBLICATION OFFICE JAPANESE JOURNAL OF APPLIED PHYSICS. TOKYO, JP, vol. 35, no. 2B, PART 1, 1 février 1996 (1996-02-01), pages 1387-1389, XP000614759 ISSN: 0021-4922**
- **PATENT ABSTRACTS OF JAPAN vol. 009, no. 305 (E-363), 3 décembre 1985 (1985-12-03) & JP 60 142578 A (MATSUSHITA DENKI SANGYO KK), 27 juillet 1985 (1985-07-27)**

EP 1 387 409 B1

• TWAROWSKI K J ET AL: "PHOTOCONDUCTIVITY EFFECTS IN POLYCRYSTALLINE SILICON AND OPTICALLY CONTROLLED COPLANAR WAVEGUIDE SWITCH PHOTOCONDUCTIVITE DANS LE SILICIUM POLYCRISTALLIN;COMMUTATEUR EN GUIDE COPLANAIRE INTEGRE ET COMMANDE OPTIQUEMENT" ANNALES DES TELECOMMUNICATIONS - ANNALS OF TELECOMMUNICATIONS, PRESSES POLYTECHNIQUES ET UNIVERSITAIRES ROMANDES, LAUSANNE, CH, vol. 56, no. 3/4, mars 2001 (2001-03), pages 208-214, XP001034548 ISSN: 0003-4347

## Description

La présente invention concerne la réalisation d'un commutateur optoélectronique ultra rapide à grand pouvoir de coupure. Ce commutateur est réalisé sous forme de circuit intégré, en technologie microruban par exemple. Il permet notamment d'effectuer au moyen de signaux de commande optiques, la commutation de signaux électriques dans des circuits intégrés hyperfréquence ou MMIC selon la dénomination anglo-saxone. Ce dispositif est par exemple destiné à être associé à des circuits micro-ondes actifs.

La photoconduction est un phénomène connu des industriels qui permet de commander la propagation d'un signal électrique dans un dispositif électronique, en utilisant un signal optique. Son application consiste par exemple à insérer dans un circuit un élément photoconducteur dont la propriété est d'avoir une conductance variable en fonction de l'éclairement auquel il est soumis. En éclairant cet élément de façon plus ou moins intense au moyen d'une source de lumière appropriée on dispose d'une conductance variable dont on peut contrôler la valeur.

Lors de l'illumination d'un élément photoconducteur il se produit une interaction entre les photons émis par la source de lumière et les atomes constituant l'élément photoconducteur. Les atomes ainsi excités voient leurs électrons situés dans la bande de valence passer dans la bande de conduction. Cette modification induit une modification de la conductivité de l'élément par effet de photoconduction. La modification apportée à l'élément est par nature réversible et cesse dès que l'illumination cesse. Les électrons ayant changé de bande d'énergie retournent alors à leur niveau initial.

Le phénomène de photoconduction est un phénomène discret qui intervient dans un matériau semi-conducteur soumis à une excitation optique dont la longueur d'onde respecte la condition :

$$\lambda \leq \frac{1.24}{E_g} \qquad (1)$$

où $\lambda$ représente la longueur d'onde de l'excitation optique exprimée en microns et $E_g$ l'énergie de bande interdite du matériau semi-conducteur considéré, exprimée en électron-volts.

La commutation optoélectronique utilise le phénomène de photoconduction dans une logique de tout ou rien. On considère alors simplement deux états distincts de l'élément photoconducteur.

L'état isolant ou état "OFF" correspond à l'état dans lequel se trouve l'élément semi-conducteur quand il n'est pas éclairé ou quand il reçoit un éclairement dont la longueur d'onde ne satisfait pas la relation (1). Dans cet état l'élément photoconducteur possède une conductance constante, très faible voire sensiblement nulle.

L'état conducteur ou état "ON" correspond à l'état opposé dans lequel se trouve l'élément semi-conducteur quand il est convenablement éclairé. Dans cet état l'élément photoconducteur voit sa conductance augmenter considérablement. Il se comporte donc comme un conducteur de faible résistance. Généralement, lors du passage à l'état "ON", l'éclairement reçu par l'élément photoconducteur est suffisant pour l'amener à une conductance proche de sa valeur maximum.

La photoconduction est notamment utilisée dans la réalisation de commutateurs optoélectroniques, encore appelés photocommutateurs, implantés sur des structures de type microruban. Sur un même substrat on peut par exemple trouver des pistes conductrices raccordées entre elles par des éléments photoconducteurs. En l'absence d'éclairement à une longueur d'onde appropriée l'élément photoconducteur est isolant. Il bloque alors la transmission du signal véhiculé par la ligne de transmission dans laquelle il est inséré. En revanche, en présence d'éclairement il devient conducteur et assure ainsi la transmission du signal.

Dans des structures de type microruban il est connu de réaliser les commutateurs optoélectroniques en utilisant un substrat photoconducteur. Sur ce substrat sont par exemple déposées des bandes conductrices formant une ligne de transmission et qui présentent des discontinuités. Ces discontinuités se comportent comme des circuits ouverts qui empêchent la transmission du signal.

En éclairant la zone de substrat située à l'endroit d'une discontinuité, il est possible de rétablir par photoconduction la continuité de la ligne. Le signal franchit alors la zone discontinue au travers du substrat devenu localement conducteur.

De tels photocommutateurs présentent dans leur principe de nombreux avantages. Ils peuvent notamment être implantés au sein de stuctures de type microruban et donc être facilement intégrés à des circuits actifs. Ils ont de plus des temps de commutation très faibles. Ils ne comportent pas, à la différence des commutateurs électromécaniques, de pièces mécaniques en mouvement et bénéficient ainsi d'un encombrement plus réduit et d'une plus longue durée de vie. Ils sont en outre peu sensibles aux perturbations.

En revanche les photocommutateurs réalisés actuellement présentent l'inconvénient d'offrir un isolement insuffisant à l'état "OFF", lorsque la fréquence du signal dont on veut empêcher la propagation dépasse par exemple quelques Gigahertz. Dans ce cas on assiste à une propagation parasite du signal dans la zone de discontinuité de la bande conductrice. La fonction de coupure n'est alors plus assurée convenablement.

Un but de l'invention est de pallier cet inconvénient. A cet effet l'invention a pour objet la réalisation de photocommutateurs ultra rapides et à grand pouvoir de coupure. Ces dispositifs comportent un substrat semi-conducteur, à haute résistivité par exemple, associé à une couche diélectrique sur laquelle est déposée une bande conductrice qui présente des discontinuités encore appelées Gaps. Au niveau de ces discontinuités la couche diélectrique est absente et laisse apparaître la couche de semi-conducteur. Le dispositif comporte également des moyens optiques permettant d'éclairer la couche de semi-conducteur au niveau des Gaps et de créer ainsi dans le semi-conducteur des zones de conduction locales ou zones de photoconduction.

Le dispositif a notamment pour avantage de diminuer sensiblement la valeur des capacités parasites induites dans les zones de discontinuité entre les éléments conducteurs et le substrat. Il accroît ainsi la gamme de fréquence dans laquelle on peut utiliser un commutateur optoélectronique.

La structure du dispositif selon l'invention est décrite dans la revendication 1 et permet avantageusement de réduire la largeur de la bande conductrice en conservant une certaine adaptation.

Par sa structure le dispositif permet de réaliser plusieurs commutateurs commandés à partir d'un même signal optique.

D'autres caractéristiques et avantages apparaîtront au travers de la description qui suit. Cette description est réalisée en regard des figures qui sont annexées et qui représentent:

La figure 1, des représentations schématiques de la structure des photocommutateurs actuels.

La figure 2, des illustrations de la réponse en fréquence des photocommutateurs actuels.

Les figures 3, des représentations schématiques de structures permettant de réaliser des photocommutateurs selon l'invention.

Les figures 4 et 5, les illustrations d'exemples de réalisation de photocommutateurs selon l'invention.

La figure 6, des illustrations schématiques d'un dispositif ayant des caractéristiques de l'invention mais n'étant pas selon l'invention.

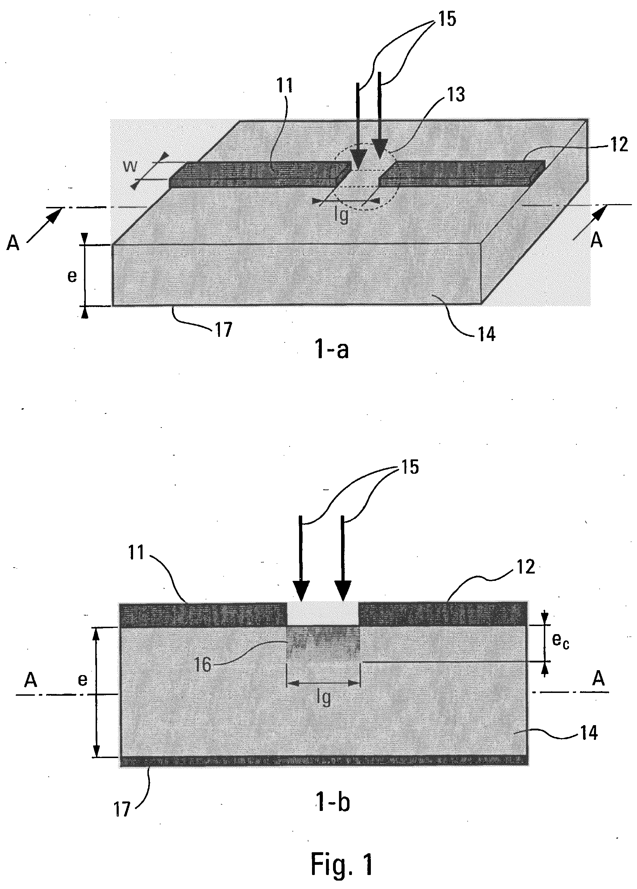

La figure 1 présentent de manière schématique la structure classique des photocommutateurs, tels qu'ils sont réalisés actuellement.

La figure 1-a est une vue schématique d'ensemble d'un photocommutateur. Ce photocommutateur est constitué d'une bande conductrice de largeur w présentant une discontinuité 13 entre ses deux éléments conducteurs 11 et 12. Cette bande conductrice est posée sur un substrat semi-conducteur 14 d'épaisseur "e". Ces éléments conducteurs 11 et 12 sont séparés l'un de l'autre par la discontinuité 13 de longueur $l_g$, appelée Gap. La structure du photocommutateur est complétée par un plan de masse 17 situé sur la face du substrat opposée à celle qui porte la bande conductrice. Dans la suite du document la face du substrat qui porte la bande conductrice sera appelée "face supérieure", par opposition à la face portant le plan de masse qui sera appelée "face inférieure".

Le substrat semi-conducteur possède au repos une conductivité très faible et le photocommutateur se comporte alors comme un circuit ouvert empêchant la propagation d'un signal au travers de la bande conductrice. Dans le cas où la bande conductrice est un élément d'une ligne de transmission, la transmission du signal sur la ligne est alors interrompue.

Quand la zone de substrat semi-conducteur située au niveau du Gap est soumise à un éclairement 15, le semi-conducteur voit ses propriétés de conduction se modifier localement. Dans cette zone, il devient un conducteur dont la résistance varie avec l'éclairement. Le photocommutateur se comporte alors comme un circuit résistif qui laisse se propager les signaux électriques sur la ligne.

La figure 1-b représente une vue schématique en coupe du même photocommutateur quand il est soumis à un éclairement 15. Sur la figure on distingue la présence dans le substrat 14, sous le Gap 13, d'une zone conductrice 16, ou zone de photoconduction, qui assure la continuité électrique des éléments conducteurs 11 et 12. Cette zone est créée par photoconduction. Son épaisseur $e_c$ est notamment fonction de la valeur coefficient d'absorption du substrat, pour la longueur d'onde de la source responsable de l'éclairement. La zone de photoconduction 16 peut avoir par exemple une épaisseur $e_c$ de quelques dizaines de microns pour une épaisseur de substrat de l'ordre d'une centaine de microns. La valeur de la conductance de la zone de photoconduction 16 est notamment fonction de la valeur de l'éclairement auquel elle est soumise.

Il est bien évident que le phénomène de photoconduction ne présente ici d'intérêt que si la zone de photoconduction a une taille au moins égale à la longueur $l_g$ séparant les éléments conducteurs. L'éclairement doit donc être réalisé dans ce sens. Dans la suite de la description on considère que tel est le cas et qu'ainsi, en présence d'éclairement, la zone de conduction locale réalisée dans le substrat assure la connexion des éléments conducteurs 11 et 12.

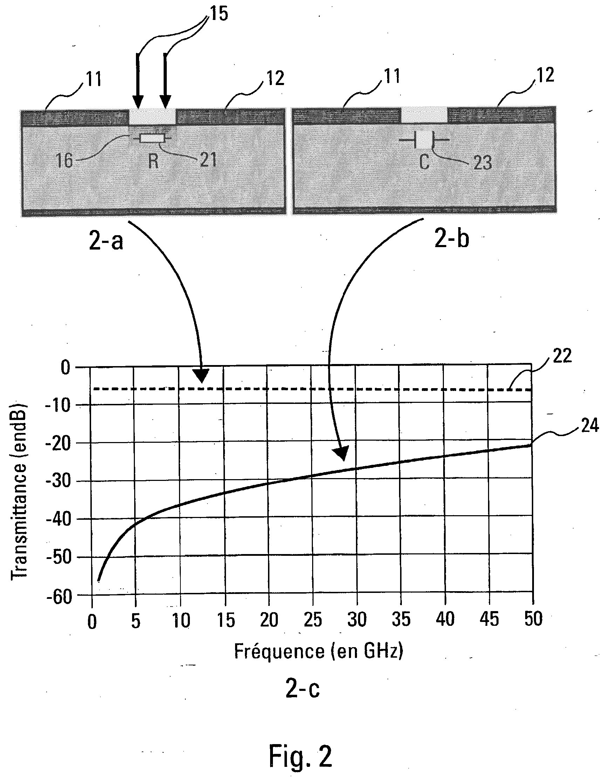

La figure 2 illustre le comportement en fréquence des photocommutateurs actuels, dans leurs deux états de fonctionnement "ON" et "OFF".

La figure 2-a illustre de manière imagée la fonction remplie par un photocommutateur quand il est soumis au niveau de la zone de discontinuité à un éclairement dont la longueur d'onde est absorbée par le substrat. Comme le montre la figure 2-a, l'éclairement du substrat induit l'apparition d'une zone conductrice 16, ou zone de photoconduction, dont le comportement en fréquence est sensiblement celui d'une résistance 21 mise en série entre les éléments conducteurs 11 et 12 de la bande conductrice. Dans la mesure où la valeur de la résistance 21 n'est pas trop élevée, le photocommutateur peut être assimilé à un court circuit, ce qui représente bien la fonction réalisée par un commutateur fermé.

La courbe 22 de la figure 2-c nous donne un exemple de ce comportement résistif, pour un photocommutateur réalisé sur un substrat en Arséniure de Gallium et présentant un Gap de longueur $l_g$ égale à 100$\mu$m. A l'état "ON" le commutateur se présente comme un élément résistif valant dans l'exemple une centaine d'ohms. La transmittance est sensiblement constante sur toute la bande de fréquence analysée, comprise entre 0 Hz et 50 GHz.

La figure 2-b quant à elle, illustre la fonction remplie par le même photocommutateur quand le Gap n'est pas soumis à un éclairement adéquat. C'est par exemple le cas lorsqu'il se trouve dans l'obscurité ou encore lorsqu'il est exposé à la lumière du jour.

Dans ce cas, la fonction que l'on souhaite réaliser est un circuit ouvert, ayant une conductance sensiblement nulle. Or les mesures effectuée montrent qu'on peut assimiler les photocommutateurs actuellement développés, bien plus à des éléments capacitifs 23 qu'à des circuits ouverts.

Leur réponse en fréquence est variable. De plus, elle est croissante en fonction de la fréquence.

La courbe 24 de la figure 2-c nous donne un exemple de ce comportement capacitif, pour un photocommutateur réalisé sur un substrat en Arséniure de Gallium et présentant un Gap de longueur $l_g$ égale à 100$\mu$m.

A l'état "OFF" le commutateur se présente comme un élément capacitif. La transmittance est d'abord très faible au voisinage du Giga Hertz puis croît sensiblement avec la fréquence. Le photocommutateur présente donc un comportement sensiblement plus proche d'un circuit passe-haut que d'un circuit ouvert.

Cet effet capacitif parasite a pour effet de dégrader très fortement les performances de coupure des photocommutateurs actuels. Il rend leur emploi difficile voire impossible dans des montages fonctionnant à des fréquences supérieures à quelques Giga Hertz.

Si on considère l'exemple de la figure 2 - c, on constate qu'à une fréquence de 10 GHz le rapport de coupure qui chiffre la différence de transmittance entre l'état "ON" et l'état "OFF" présenté par un photocommutateur est inférieure à 40dB. Il devient même inférieur à 30dB quand la fréquence avoisine les 20GHz. La fonction de coupure est alors mal assurée. L'effet capacitif parasite qui devient prépondérant à mesure que la fréquence augmente, a pour conséquence de limiter la bande passante d'utilisation des photocommutateurs actuels.

Des travaux réalisés par la déposante montrent que cet effet capacitif parasite a plusieurs causes parmi lesquelles on peut citer :

- La structure même du Gap constitué des extrémités des deux éléments 11 et 12 de la bande conductrice et de la zone de discontinuité qui les sépare. Cette structure est celle d'un condensateur à air, dont la capacité est par ailleurs très faible.
- La nature du substrat semi-conducteur dont la permittivité relative $\varepsilon_r$ est de l'ordre de 10. Cette valeur élevée de $\varepsilon_r$ se traduit notamment par l'existence d'un effet capacitif parasite important au niveau du substrat.

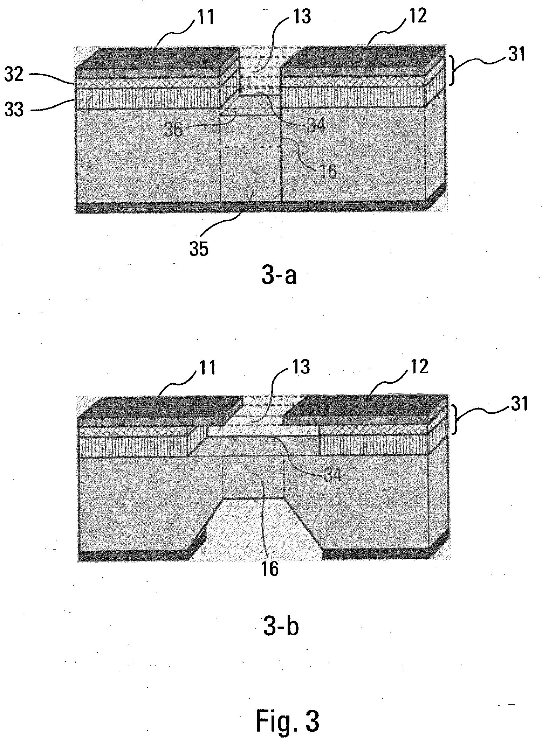

Pour résoudre le problème posé par l'existence de cette capacité parasite le dispositif selon l'invention possède une structure différente de celle communément utilisée. Cette structure originale peut prendre plusieurs formes. La figure 3 présente deux exemples possibles de réalisations de photocommutateurs selon l'invention.

Dans ces deux exemples l'obtention d'une bonne isolation à des fréquences élevées est obtenue en diminuant la valeur de la capacité parasite présente dans la zone du Gap. Le résultat est notamment obtenu en minimisant la valeur de la capacité parasite liée à la proximité du substrat sur lequel est posée la bande conductrice. Pour ce faire on isole le Gap du substrat au moyen d'une couche d'air. On tend ainsi diminuer l'influence du substrat et à ramener la valeur de cette capacité parasite à celle de la capacité propre à la structure du Gap, cette capacité ayant par ailleurs une faible valeur. Pour obtenir ce résultat plusieurs structures sont envisageables.

La figure 3-a montre un mode de réalisation possible dans lequel une couche de matériau diélectrique 31 est intercalée entre la bande conductrice et le substrat. Cette couche dont la permittivité est bien inférieure à celle du substrat, peut être constituée de deux sous-couches 32 et 33 : une couche de Nitrure et une couche de polyamide par exemple.

Cette couche diélectrique offre l'avantage de diminuer la valeur des capacités de liaison existant entre les éléments 11 et 12 de la bande conductrice et le substrat. Elle équivaut notamment à une mise en série de capacités de plus faibles valeurs avec la capacité induite par le substrat.

La couche diélectrique est localement interrompue dans la zone du Gap et laisse ainsi sa place à une couche d'air 34 entre le substrat et le Gap. L'interruption locale de la couche diélectrique au niveau du gap et son remplacement par une couche d'air contribue avantageusement à diminuer la valeur de la capacité parasite, la permittivité de l'air étant voisine de celle du vide.

L'interruption locale de la couche diélectrique au niveau du Gap présente également un autre avantage. La zone du gap correspond également à la zone de photoconduction du substrat. Or la présence dans cette zone d'une couche de matériau diélectrique peut être source d'une forte réflexion du rayonnement éclairant, à l'interface entre le substrat 14 et la couche 31 de matériau diélectrique. Supprimer la couche diélectrique permet donc de garantir des conditions d'éclairement optimales.

Sur la figure 3-a on constate également une réduction d'épaisseur de la partie 35 du substrat située sous le Gap. Cette réduction d'épaisseur dans la zone du Gap a pour effet de diminuer la valeur de la capacité parasite qui est directement liée au substrat. Elle contribue de manière sensible à la réduction de la capacité globale du photocommutateur.

Dans ce mode de réalisation, la réduction de l'épaisseur du substrat dans la zone 35 est réalisée sur la face supérieure du substrat. La zone 36 correspondant à une réduction de l'épaisseur du substrat, forme une couche d'air supplémentaire qui accroît l'isolement de la zone du Gap vis à vis du substrat.

Dans ce mode de réalisation, la valeur maximale de la réduction de l'épaisseur du substrat est limitée par la nécessité de conserver les caractéristiques du photocommutateur. L'épaisseur de la zone 36 laissée vide ne doit en effet pas nuire au fonctionnement du commutateur notamment à l'état "ON". Une zone 36 de taille trop importante donnerait notamment un caractère capacitif à l'état "ON", état que l'on souhaite avant tout résistif.

La figure 3-b présente un autre mode de réalisation possible d'un photocommutateur selon l'invention. Dans ce mode de réalisation comme dans celui de la figure 3-a, les éléments 11 et 12 de la bande conductrice reposent sur une couche de matériau diélectrique. De même, cette couche diélectrique est interrompue au niveau du Gap, permettant ainsi, dans la zone du gap, d'isoler la bande conductrice du substrat par l'intermédiaire d'une couche d'air 34.

En revanche, à la différence du mode de réalisation précédent, la réduction d'épaisseur de la partie 35 du substrat située sous le Gap est réalisée sur la face inférieure du substrat. De cette façon il est possible d'opérer une réduction d'épaisseur plus importante que dans le mode de réalisation précédent, sans altérer le fonctionnement du photocommutateur, en particulier à l'état "ON". On peut par exemple laisser une épaisseur de substrat sensiblement égale à l'épaisseur de la zone de photoconduction. Ce mode de réalisation permet notamment de réduire de manière sensible la valeur de la capacité parasite, directement liée à l'épaisseur du substrat.

Cette réduction de l'épaisseur du substrat dans la zone du Gap s'accompagne également d'un détourage du plan de masse. Ce détourage permet d'accéder au substrat par la face inférieure du circuit. Ainsi, dans la mesure où l'épaisseur du substrat dans la zone du Gap est ramenée à l'épaisseur d'absorption du rayonnement qui éclaire le substrat, il est possible de réaliser l'éclairement du substrat par la face inférieure.

Dans le mode de réalisation présenté sur la figure 3-b on peut également constater que l'interruption de la couche diélectrique s'étend sur surface plus importante que dans le mode précédent. La couche diélectrique laisse ainsi place à une couche d'air 34 qui entoure plus largement le Gap et qui renforce avantageusement l'isolement du Gap vis à vis du substrat.

Les deux modes de réalisation décrits ici sont basés sur une structure multicouche qui présentent l'avantage de diminuer de manière sensible la valeur de la capacité parasite Cette structure multicouche est avantageusement complétée par la réduction de l'épaisseur de la couche de substrat au niveau du Gap. Par rapport à la structure classique consistant à déposer la bande conductrice directement sur le substrat semi-conducteur, cette structure multicouche permet d'obtenir un rapport de coupure fortement amélioré. Le fonctionnement du photocommutateur à l'état "OFF" est comparable en terme d'isolation à celui d'un commutateur classique, de type mécanique par exemple.

Grâce au type de structure selon l'invention présenté à la figure 3, il est par exemple possible de réaliser des photocommutateurs ultra rapides, présentant un rapport de coupure entre l'état "ON" et l'état "OFF" d'environ une cinquantaine de dB à une fréquence se situant autour de 20 GHz.

Ces photocommutateurs sont commandés par des signaux optiques généralement issus de sources laser dont la longueur d'onde est fonction du matériau constituant le substrat.

On peut ainsi par exemple réaliser des photocommutateurs dont la commutation est commandée par un éclairement à une longueur d'onde située autour de 860 nm. De tels photocommutateurs sont notamment réalisés sur des substrats d'arséniure de Gallium simple, obtenu par exemple par simple croissance épitaxiale ou encore sur des substrats d'arséniure de Gallium Basse Température (GaAs BT). Un substrat d'arséniure de Gallium Basse Température présent l'avantage d'offrir une absorption plus forte du rayonnement éclairant que l'arséniure de Gallium standard ainsi que de plus faibles temps de commutation, de l'ordre de la femtoseconde.

On peut également réaliser des photocommutateurs dont la commutation est commandée par un éclairement à une longueur d'onde située par exemple autour de 1.55 $\mu$m. Dans ce cas le substrat utilisé est un mélange de Gallium et d'indium combiné à l'Arsenic ($In_{0.53}Ga_{0.47}As$). Ce substrat présente une bonne absorption des rayonnements autour de cette longueur d'onde.

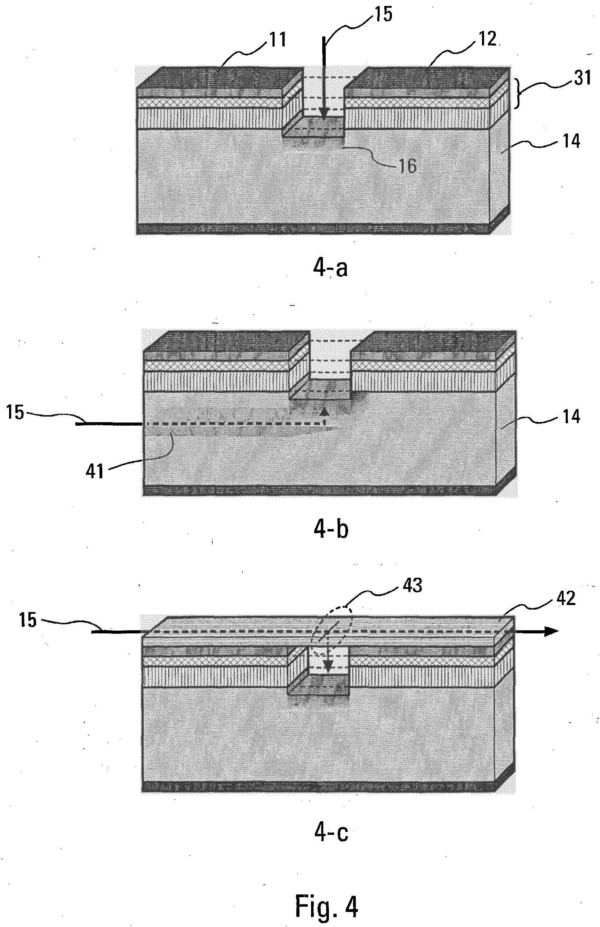

La figure 4 présente des exemples types de réalisation de photocommutateurs selon l'invention. Ces exemples de réalisation mettent en oeuvre la structure décrite par la figure 3-a et présente différentes solutions permettant d'éclairer le substrat dans la zone du Gap.

Dans l'exemple de la figure 4-a l'éclairement 15 de la zone de substrat située au niveau du Gap est effectué de manière directe par la face supérieure du circuit. La couche diélectrique 31 étant interrompu dans la zone du Gap le substrat reçoit l'intégralité du rayonnement émis.

Ce mode simple de réalisation peut par exemple être avantageusement utilisé dans le cas où l'on souhaite réaliser un dispositif comportant un seul photocommutateur. La source étant située à proximité du gap, la transmission du signal lumineux peut se faire de manière directe. La source peut par exemple être positionnée en regard du Gap au moyen d'une structure non décrite ici.

La figure 4-b présente un autre mode de réalisation dans lequel l'éclairement 15 du substrat est réalisé en interne, au moyen d'un rayonnement guidé à l'intérieur du substrat. Le guidage du rayonnement peut par exemple être réalisé en intégrant une structure de guide d'onde optique dans le substrat.

Ce mode de réalisation, plus complexe que le précédent, présente l'avantage d'intégrer le dispositif d'éclairement à la structure du circuit qui porte le photocommutateur. La source lumineuse peut notamment être déportée et raccordée au circuit à l'aide de la connectique appropriée.

La figure 4-c présente quant à elle un mode de réalisation qui rend possible l'éclairement 15 de plusieurs zones de substrat avec une seule source. On peut notamment de la sorte réaliser plusieurs photocommutateurs commandés à partir d'un même signal optique. Ce signal optique est par exemple guidé vers les différents photocommutateurs par un dispositif de guidage optique 42 situé sur la face supérieure du circuit. Ce dispositif de guidage présente la particularité de comporter des portions semi-réfléchissantes 43 dans la zone des Gaps des différents photocommutateurs. Comme dans l'exemple de la figure 4-b la source lumineuse est dans ce cas raccordée à la structure intégrant les photocommutateurs à l'aide d'une connectique appropriée.

Comme il a été dit précédemment, ce mode de réalisation présente l'avantage de rendre possible la commande de plusieurs photocommutateurs à partir d'un même signal optique. Si la longueur des chemins optiques est choisie judicieusement, il est notamment possible de réaliser un échantillonnage d'un signal électrique à des instants différents dans une même période du signal.

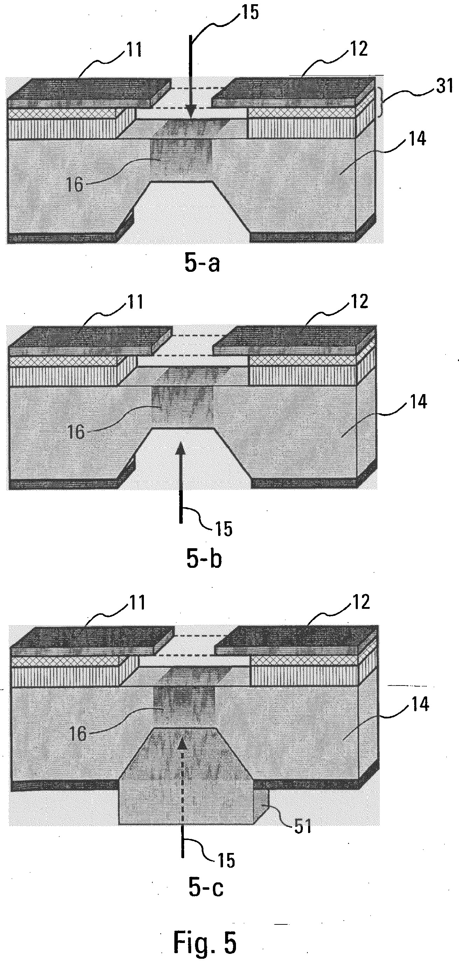

La figure 5 présente des exemples types de réalisation de photocommutateurs selon l'invention qui mettent en oeuvre la structure décrite par la figure 3-b. Cette structure qui comporte une réduction de l'épaisseur du substrat dans la zone du Gap, permet de réaliser un éclairement qui modifie dans cette zone la conductivité du substrat sur toute son épaisseur. De cette façon, comme l'illustrent les figures 5-a et 5-b, il est avantageusement possible de réaliser l'éclairement 15 du substrat soit par la face supérieure, soit par la face inférieur du circuit. L'éclairement est ici réalisé de façon directe par une source lumineuse appropriée.

Sur la figure 5-c présente une structure plus intégrée qui tire avantageusement parti de l'accessibilité du substrat à un éclairement par la face inférieure. L'éclairement du substrat n'est pas directement réalisé par la source mais au moyen d'un dispositif 51 tel que par exemple un guide d'onde optique.

Ce type de réalisation présente notamment l'avantage d'intégrer le dispositif d'éclairement, à la structure du circuit qui porte le photocommutateur. De plus comme dans le mode de réalisation présenté à la figure 4-c, un tel mode de réalisation rend avantageusement possible la commande de plusieurs photocommutateurs à partir d'un seul signal optique. Ce type de réalisation présente encore l'avantage de ne pas recouvrir la face supérieure du circuit. Il laisse ainsi libre accès à cette face.

Les types de réalisation présentés sur les figures 4 et 5 sont donnés ici à titre d'exemple et ne représentent bien entendu pas un état exhaustif. D'autres types de réalisation basés sur les structures présentées sur la figure 3 sont envisageable, notamment en ce qui concerne la façon d'exposer le substrat à un éclairement approprié. De plus, par soucis de clarté, les représentations des figures 4 et 5 montrent des photocommutateurs isolés. Néanmoins, les types de réalisation présentés en exemples sont bien évidemment destinés à être intégrés sur un même circuit avec d'autres dispositifs, notamment d'autres photocommutateurs ou encore d'autres dispositifs électroniques.

En raison de leur structure les photocommutateurs selon l'invention permettent d'obtenir des temps de commutation très faibles, de quelques centaines de picosecondes par exemple, et un découplage de l'ordre d'une cinquantaine de décibels entre l'état "ON" et l'état "OFF" pour une fréquence située autour de 20 GHz. En comparaison avec d'autres types de commutateurs Ils présentent une bande passante élevée pouvant notamment atteindre 50GHz. Ils peuvent donc avantageusement être utilisé dans divers montages en lieu et place de commutateurs mécaniques ou électromécaniques, comme par exemple dans le cas de circuits à structure microruban.

Les propriétés des photocommutateurs selon l'invention peuvent être mises à profit dans différents montages électroniques.

Ces photocommutateurs peuvent naturellement être utilisés comme circuits échantillonneurs à très grande rapidité et permettre par exemple l'échantillonnage direct d'un signal sur une porteuse hyperfréquence.

Ils peuvent encore être insérés dans la boucle de réaction d'un montage amplificateur et jouer le rôle d'un circuit de commande de gain. Dans ce cas, le commutateur est par exemple employé à l'état "ON". La variation de la valeur de la résistance équivalente du commutateur en fonction de la valeur de l'éclairement apporté au substrat, est utilisée pour modifier la valeur du gain de l'amplificateur. On obtient ainsi un amplificateur dont le gain est commandé par un signal optique.

Les photocommutateurs selon l'invention peuvent également être utilisés comme circuits d'accord commandables dans des montages oscillateurs ou encore comme éléments déphaseurs. Dans ces deux cas c'est notamment l'élément capacitif lié à la structure du photocommutateur qui est mis à profit. Les cas d'emploi de photocommutateurs selon l'invention cités ici sont donnés à titre d'exemples. Ils ne constituent évidemment pas une liste exhaustive.

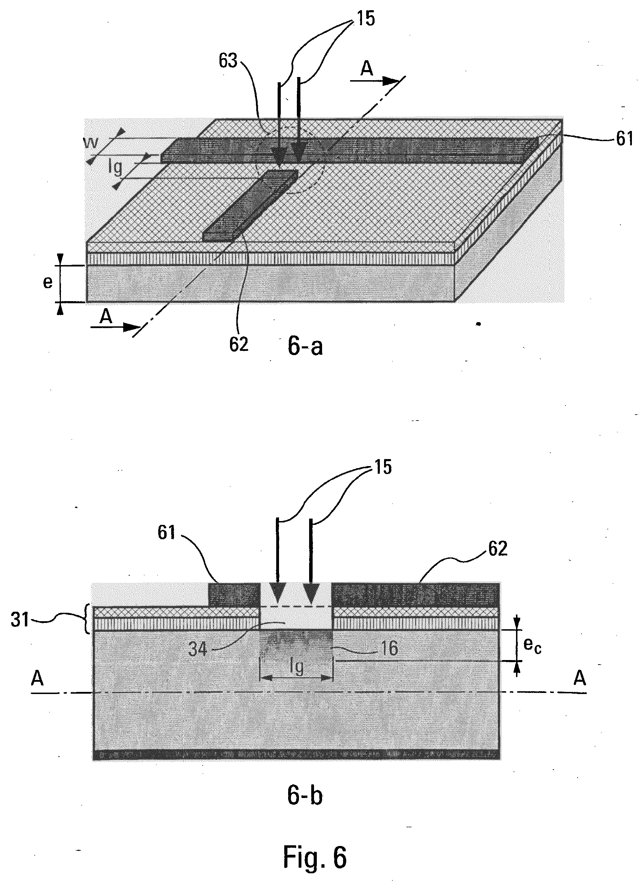

La figure 6 illustre une forme particulière qu'on peut utiliser pour le dispositif selon l'invention. Dans la description qui précède, le dispositif photocommutateur selon l'invention est notamment utilisé pour rétablir sur commande la continuité d'une ligne conductrice présentant une discontinuité 13. Dans le cas présenté à la figure 6, le dispositif permet par exemple de réaliser sur commande la connexion de deux lignes distinctes

La figure 6-a présente un exemple de structure à deux lignes conductrices 61 et 62 perpendiculaires séparées par une zone de connexion 63, de largeur sensiblement équivalente à celle de la zone de discontinuité 13 existant dans la forme du dispositif décrite précédemment. Dans cette structure, la zone de connexion joue sensiblement le même rôle que la zone de discontinuité. C'est dans cette zone qu'est appliqué l'éclairement.

Le rôle rempli par le dispositif selon l'invention reste le même que dans la forme décrite précédemment, ainsi que son mode de fonctionnement. En l'absence d'éclairement la zone de connexion se présente comme un circuit ouvert, les deux lignes étant électriquement isolées l'une de l'autre. En revanche si la zone de connexion est soumise à un éclairement approprié elle se présente alors comme un court circuit qui relie les deux lignes. La conduction est alors réalisée au travers du substrat devenu localement conducteur.

Comme l'illustre la figure 6-b, le photocommutateur mis en place au niveau de la zone de connexion 63 a une structure sensiblement identique à celle du photocommutateur mis en place au niveau de la zone de discontinuité 13 de la figure 3-a par exemple. On y retrouve notamment une zone de photoconductivité 16 équivalente à celle de la figure 3-a, ainsi que la présence d'une couche d'air 34 entre la zone de connexion et le substrat.

De ce fait, les modes de réalisation illustrés par les figures 3, 4 et 5 restent valables pour la réalisation du dispositif dans cette forme particulière, adaptée notamment à la connexion de deux lignes. Le dispositif conserve ainsi ses propriétés avantageuses citées dans la description qui précède, notamment en ce qui concerne l'isolement des deux lignes en l'absence d'éclairement.

La disposition relative des deux lignes, perpendiculairement l'une à l'autre, est présentée ici à titre d'exemple et n'est en rien restrictive. Le rapprochement des deux lignes peut notamment se faire sous un angle quelconque, la seule caractéristique importante étant l'existence d'une zone de connexion

Cette forme particulière du dispositif selon l'invention trouve avantageusement son utilité dans la réalisation de certaines fonctions électroniques sur des circuits MMIC.

Il est par exemple possible d'utiliser avantageusement le dispositif selon l'invention pris sous cette forme, pour réaliser un atténuateur dont la valeur de l'atténuation est commandable. Pour ce faire il suffit par exemple de relier à la masse du circuit l'extrémité de la ligne 62 opposée à la zone de connexion et de faire varier la valeur de l'éclairement auquel est soumise la zone de connexion. Ainsi le niveau du signal se propageant sur la ligne 61 se verra affaibli du niveau de signal prélevé par la ligne 62 et conduit à la masse. Si l'éclairement devient suffisant le signal se propageant sur la ligne 61 est alors sensiblement mis à la masse.

Il est également possible d'utiliser avantageusement le dispositif pris sous cette forme comme dispositif sommateur. Dans ce cas la ligne 62 n'est bien sûr pas reliée à la masse du circuit mais véhicule un signal. Ce signal sera combiné au signal se propageant sur la ligne 61, dès lors que la zone de connexion aura été soumise à un éclairement adéquat.

Les deux exemples d'utilisation cités ici ne constituent bien entendu pas une liste exhaustive. Toute application répondant au besoin de connecter sur commande deux lignes conductrices peut être envisagée.

## Revendications

1. Dispositif de commutation optoélectronique hyperfréquence, comportant au moins :

   - deux éléments conducteurs espacés l'un de l'autre,
   - une couche diélectrique (31) à faible permittivité relative sur laquelle sont appliqués les éléments conducteurs,
   - une couche de substrat semi-conducteur sur laquelle sont appliqués la couche diélectrique et les éléments conducteurs,
   - des moyens d'éclairement qui illuminent au moins une partie de l'espace séparant les deux éléments conducteurs sur une zone de photoconduction (16) s'étendant au moins d'un élément conducteur à l'autre et qui modifient la conductivité du substrat dans la zone de photoconduction pour le rendre localement conducteur,

   ledit dispositif étant **caractérisé en ce qu'**au niveau de la zone de photoconduction, l'épaisseur du substrat est réduite afin de diminuer la valeur de la capacité parasite liée au substrat.

2. Dispositif selon la revendication 1, **caractérisé en ce que** les deux éléments conducteurs constituent les deux éléments (11 et 12) d'une ligne conductrice unique présentant une discontinuité (13), la zone de photoconduction (16) étant située au niveau de la discontinuité.

3. Dispositif selon la revendication 1, caractérisé en ce les deux éléments conducteurs constituent deux lignes conductrices (61 et 62) distinctes bordant la zone de photoconduction (16).

4. Dispositif selon l'une quelconque des revendications précédentes, **caractérisé en ce qu'**à l'endroit de la zone de photoconduction (16) la couche diélectrique est interrompue sur une zone incluant la zone de photoconduction et il y a une couche d'air (34) dans cette zone interrompue permettant d'isoler les éléments conducteurs vis à vis substrat dans la zone d'éclairement.

5. Dispositif selon la revendication 4, **caractérisé en ce que** la couche d'air est transparente pour le signal optique et permet d'obtenir un éclairement du substrat sans réflexion.

**6.** Dispositif selon l'une quelconque des revendications précédentes, **caractérisé en ce que** la réduction de l'épaisseur du substrat est réalisée sur la face supérieure du substrat, l'espace libéré formant une couche d'air (36).

**7.** Dispositif selon l'une quelconque des revendications précédentes, **caractérisé en ce que** l'éclairement (15) du substrat est réalisé par un signal optique issu d'une source éclairant directement le substrat par la face supérieure du circuit.

**8.** Dispositif selon la revendication précédente, **caractérisé en ce que** la source éclairant le substrat est une fibre optique.

**9.** Application du dispositif selon l'une quelconque des revendications précédentes, à l'échantillonnage ultra rapide de signaux hyperfréquence se propageant sur la ligne conductrice.

**10.** Application du dispositif selon l'une quelconque des revendications 1 à 8, à la commande de gain d'amplificateurs hyperfréquence.

**11.** Application du dispositif selon l'une quelconque des revendications 1 à 8, à la réalisation de circuits déphaseurs hyperfréquence.

**12.** Application du dispositif selon l'une quelconque des revendications 1 à 8, à la réalisation de circuits oscillateurs commandables en fréquence.

**Patentansprüche**

**1.** Optoelektronische Mikrowellenschaltvorrichtung, die wenigstens Folgendes umfasst:

- zwei leitende Elemente, die voneinander beabstandet sind;
- eine dielektrische Schicht (31) mit niedriger relativer Permittivität, auf die die leitenden Elemente aufgebracht sind;
- eine Halbleitersubstratschicht, auf die die dielektrische Schicht und die leitenden Elemente aufgebracht sind;
- Beleuchtungsmittel, die wenigstens einen Teil des Raums beleuchten, der die zwei leitenden Elemente auf einer fotoleitenden Zone (16) trennt, die wenigstens von einem leitenden Element zum anderen verläuft und die Leitfähigkeit des Substrats in der fotoleitenden Zone modifizieren, um sie lokal leitend zu machen;

wobei die Vorrichtung **dadurch gekennzeichnet ist, dass** die Dicke des Substrats in der fotoleitenden Zone begrenzt ist, um den Wert der mit dem Substrat assoziierten parasitären Kapazität zu reduzieren.

**2.** Vorrichtung nach Anspruch 1, **dadurch gekennzeichnet, dass** die zwei leitenden Elemente die zwei Elemente (11 und 12) einer einzelner Leitung bilden, die eine Diskontinuität (13) hat, wobei sich der fotoleitende Zone (16) an der Diskontinuität befindet.

**3.** Vorrichtung nach Anspruch 1, **dadurch gekennzeichnet, dass** die zwei leitenden Elemente zwei getrennte Leitungen (61 und 62) bilden, die an die fotoleitende Zone (16) angrenzen.

**4.** Vorrichtung nach einem der vorherigen Ansprüche, **dadurch gekennzeichnet, dass** die dielektrische Schicht an der Stelle der fotoleitenden Zone (16) in einer Zone unterbrochen ist, die die fotoleitende Zone beinhaltet, und dass es eine Luftschicht (34) in der unterbrochenen Zone gibt, die es zulässt, dass die leitenden Elemente relativ zu dem Substrat in der Beleuchtungszone isoliert werden.

**5.** Vorrichtung nach Anspruch 4, **dadurch gekennzeichnet, dass** die Luftschicht für das optische Signal transparent ist und die Erzielung einer reflexionsfreien Beleuchtung des Substrats zulässt.

**6.** Vorrichtung nach einem der vorherigen Ansprüche, **dadurch gekennzeichnet, dass** die Reduzierung der Dicke des Substrats auf der Oberseite des Substrats realisiert wird, wobei der freie Raum eine Luftschicht (36) bildet.

**7.** Vorrichtung nach einem der vorherigen Ansprüche, **dadurch gekennzeichnet, dass** die Beleuchtung (15) des Substrats durch ein optisches Signal realisiert wird, das von einer Quelle kommt, die das Substrat via die Oberseite der Schaltung direkt beleuchtet.

**8.** Vorrichtung nach dem vorherigen Anspruch, **dadurch gekennzeichnet, dass** die das Substrat beleuchtende Quelle eine optische Faser ist.

**9.** Anwendung der Vorrichtung nach einem der vorherigen Ansprüche auf das ultraschnelle Abtasten von Mikrowellensignalen, die sich auf der Leitung ausbreiten.

**10.** Anwendung der Vorrichtung nach einem der Ansprüche 1 bis 8 auf die Verstärkungsregelung von Mikrowellenverstärkern.

**11.** Anwendung der Vorrichtung nach einem der Ansprüche 1 bis 8 auf die Herstellung von Mikrowellenphasenschieberschaltungen.

**12.** Anwendung der Vorrichtung nach einem der Ansprüche 1 bis 8 auf die Herstellung von frequenzsteuerbaren Oszillationsschaltungen.

**Claims**

1. A microwave frequency optoelectronic switching device, comprising at least:

   - two conducting elements spaced apart from each other;
   - one dielectric layer (31) with low relative permittivity, on which said conducting elements are applied;
   - one layer of semi-conducting substrate, on which said dielectric layer and said conducting elements are applied;
   - illumination means that illuminate at least part of the space that separates said two conducting elements on a photoconductive area (16) extending at least from one conducting element to the next and that modify the conductivity of said substrate in said photoconductive area in order to make it locally conducting;

   said device being **characterised in that**, in said photoconductive area, the thickness of the substrate is limited so as to reduce the value of the spurious capacitance associated with said substrate.

2. The device according to claim 1, **characterised in that** said two conducting elements form the two elements (11 and 12) of a single conducting line having a discontinuity (13), said photoconductive area (16) being located at the level of said discontinuity.

3. The device according to claim 1, **characterised in that** said two conducting elements form two distinct conducting lines (61 and 62) bordering said photoconductive area (16).

4. The device according to any one of the preceding claims, **characterised in that**, at the site of said photoconductive area (16), said dielectric layer is interrupted in a zone that includes said photoconductive area and there is an air layer (34) in said interrupted area that allows said conducting elements to be isolated relative to the substrate in said illumination zone.

5. The device according to claim 4, **characterised in that** said air layer is transparent to the optical signal and allows to obtain an illumination without reflexion of the substrate.

6. The device according to any one of the preceding claims, **characterised in that** the reduction in the thickness of said substrate is realised on the upper surface of said substrate, with the freed space forming an air layer (36).

7. The device according to any one of the preceding claims, **characterised in that** the illumination (15) of said substrate is realised by an optical signal coming from a source that directly illuminates said substrate via the upper face of said circuit.

8. The device according to the preceding claim, **characterised in that** said source illuminating said substrate is an optical fibre.

9. An application of the device according to any one of the preceding claims to the ultrafast sampling of microwave signals propagating on said conducting line.

10. The application of the device according to any one of claims 1 to 8 to the gain control of microwave amplifiers.

11. The application of the device according to any one of claims 1 to 8 to the production of microwave phase-shift circuits.

12. The application of the device according to any one of claims 1 to 8 to the production of microwave phase shifter circuits.

1-a

1-b

Fig. 1

Fig. 2

3-a

3-b

Fig. 3

4-a

4-b

4-c

Fig. 4

5-a

5-b

5-c

Fig. 5

6-a

6-b

Fig. 6